(19)

Europäisches
Patentamt
European
Patent Office
Office européen
des brevets

(11) **EP 1 788 704 A1**

(12) **EUROPEAN PATENT APPLICATION**

(43) Date of publication:
**23.05.2007 Bulletin 2007/21**

(51) Int Cl.:
**H03K 4/06** $^{(2006.01)}$

(21) Application number: **05425812.4**

(22) Date of filing: **17.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **STMicroelectronics S.r.l.**
**20041 Agrate Brianza (Milano) (IT)**

(72) Inventors:
• **Guanziroli, Federico**
 **20030 Lentate sul Seveso (MI) (IT)**

• **Nicollini, Germano**
 **29100 Piacenza (IT)**
• **Confalonieri, Pierangelo**
 **20040 Caponago (MI) (IT)**

(74) Representative: **Siniscalco, Fabio et al**
**JACOBACCI & PARTNERS S.p.A.**
**Via Senato, 8**
**20121 Milano (IT)**

(54) **Triangular wave generator**

(57)     A generating device (100) of a triangular signal ($v_{tri}(t)$) comprises an input device (101) provided with first terminals (102, 103) in order to receive a first ($V_A$) and second (GND) potentials and with differential output terminals (104, 105) in order to send an intermediate signal ($i_{int}(t)$) to an integration device (501).

This integration device comprises differential input terminals (IN1, IN2) connected to the output terminals of the input device and first output terminals (OUT1, OUT2) in order to provide the triangular signal ($V_{tri}(t)$).

The generating device is characterized in that the input device comprises switching means ($T_1$, $T_2$, $T_3$, $T_4$) which can be activated/deactivated by means of external selection signals ($S_1$, $S_2$) in order to connect the input terminals (IN1, IN2) to the first terminals of the input device according to alternative configurations. Furthermore, these external selection signals are generated in response to a timing signal (CK) having a substantially constant frequency ($f_{ck}$).

FIG.1

EP 1 788 704 A1

**Description**

The present invention relates to the integrated electronic devices, particularly the invention relates to a triangular signal generating device.

In particular applications such as, for example, in the manufacturing of class-D integrated amplifiers for portable devices, it is necessary to have a triangular signal generator which is also completely integrated on the same amplifier semiconductor chip.

A triangular signal generator of the integrated type and which is known in the state of the art is described in the document "The Class-D Amplifier" from the book Introduction to Electroacustic and Audio Amplifier Design, Second Edition - Revised Printing, by W. Marshall Leach, Jr., published by Kendall/Hunt, 2001. Particularly, this triangle generator comprises an integrator controlling a comparator being connected as a Schmitt trigger. A rectangular-wave signal obtained in output from the comparator controls an integrator input in order to generate the triangular signal.

It shall be noted that the triangular signal produced by said generator has a peak amplitude dependent on a power supply potential. On the other hand, a frequency of this signal depends on a product RC, therefore it may vary with process and temperature.

This frequency variability of the triangular signal generated is unacceptable for many applications among which, for example, the manufacturing of class-D integrated electronic amplifiers.

The object of the present invention is to provide a triangular signal generation device which overcomes the drawbacks and limits of the known triangle generators.

This object is achieved by a generating device such as described in the annexed claim 1.

Alternative embodiments of the device of the invention are indicated in the dependent claims.

The characteristics and the advantages of the present invention will be better understood from the following detailed description of an embodiment thereof, which is given by way of illustrative and non-limiting example with reference to the annexed drawings, in which:

- Fig. 1 shows a circuit diagram of a triangular signal generating device in accordance with the invention;
- Fig. 2 shows a logic circuit associable to the generating device of Fig. 1.

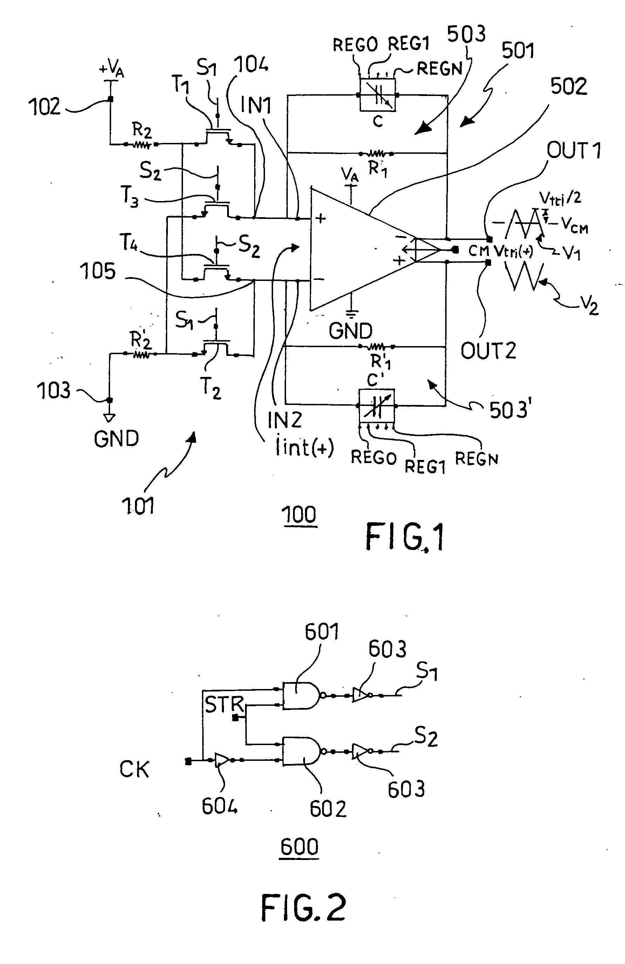

A circuit diagram of a generating device 100 of a triangular signal $v_{tri}(t)$ can be described with reference to Figs. 1 and 2.

With reference to Fig. 1, the generating device 100 of the triangular signal $v_{tri}$ (t) comprises an integration device or integrator 501 provided by means of a feedback operational amplifier 502.

It shall be noted that the operational amplifier 502 comprises polarization terminals connectable to one another between a power supply potential $V_A$ and a ground potential GND.

Furthermore, the integrator 501 is provided with an input port and an output port, each of which comprises electric terminals of the differential type. Particularly, the input port of the integrator 501 comprises a first IN1 and second IN2 input terminals. The output port of the integrator 501 comprises a first OUT1 and second OUT2 output terminals.

Moreover, the first input terminal IN1 can be connected to the first output terminal OUT1 by means of a first feedback electric network 503, whereas the second input terminal IN2 can be connected to the second output terminal OUT2 by means of a second feedback electric network 503'.

This first/second feedback electric network 503/503' comprises a first/second resistance $R_1/R_1$' connected in parallel to a first/second capacitor C/C'.

Particularly, the resistances $R_1$ and $R_1$' are equal to each other, i.e. $R_1=R_1$'. Furthermore, the capacitors C and C' are also equal to each other and have a capacitance value adjustable by means of a plurality of digital signals REG0, REG1, ..., REGN.

Particularly, it shall be noted that each of said first C and second C' capacitors includes a plurality of capacitors connectable in parallel to one another based on the binary levels (0 and 1) of these digital signals REG0, REG1, ..., REGN.

In addition, it shall be noted that the operational amplifier 502 is also provided with a common-mode input terminal CM, being generally fixed to the potential $V_A/2$.

Moreover, the generating device 100 comprises an input device 101. This input device 101 is provided with a first 102 and second 103 terminals in order to receive the power supply potential $V_A$ and the ground potential GND, respectively.

In addition, the input device 101 comprises a first output port connected to the input port of the integrator 501 in order to send the latter an intermediate current signal $i_{int}(t)$ to be integrated. Particularly, this first output port comprises a further first output terminal 104 connected to the first input terminal IN1 of the integrator 501 and a further second output terminal 105 connected to the second input terminal IN2. It shall be noted that this intermediate current signal $i_{int}$ (t) is an input signal of the differential type to the integrator 501. It shall be noted that the input device 101 comprises a multiplicity of switching means $T_1$, $T_2$, $T_3$, and $T_4$. These switching means are electronic switches $T_1$, $T_2$, $T_3$, $T_4$ which

can be activated and deactivated by means of external selection signals $S_1$ and $S_2$ in order to connect the first IN1 and second IN2 input terminals of the integrator 501 to the first 102 and second 103 terminals, respectively, according to alternative configurations.

For example, said electronic switches $T_1$, $T_2$, $T_3$, $T_4$ are pass-transistors of the N-MOS-type.

Particularly, the input device 101 comprises a first electronic switch $T_1$ having the source terminal connected to the first input terminal IN1 and the drain terminal connected to the first terminal 102, i.e. the power supply potential $V_A$, by means of a third resistance $R_2$. Furthermore, a second electronic switch $T_2$ has the drain terminal connected to the second input terminal IN2 and the source terminal connected to the second terminal 103, i.e. the ground potential GND, through a fourth resistance $R_2'$. These third $R_2$ and fourth $R_2'$ resistances are equal to each other, i.e. $R_2=R_2'$.

In addition, a third switch $T_3$ of the input device 101 has the drain terminal connected to the first input terminal IN1 and the source terminal connected to the second terminal 103 through the fourth resistance $R_2'$. On the other hand, a fourth switch $T_4$ has the source terminal connected to the second input terminal IN2 and the drain terminal connected to the first terminal 102 through said third resistance $R_2$. Particularly, with reference to Fig. 1, it shall be noted that the gate terminals of the first $T_1$ and second $T_2$ switches can be controlled by means of a first external selection signal $S_1$, whereas the gate terminals of the third $T_3$ and fourth $T_4$ switches can be controlled by means of a second external selection signal $S_2$. These selection signals $S_1$ and $S_2$ are digital signals such that they take two different logic levels (0 and 1).

Furthermore, these signals represent the outputs of a logic circuit 600 being schematically illustrated in Fig. 2.

This logic circuit 600 comprises a first 601 and second 602 double-input digital gates NAND. Particularly, both the digital gates NAND 601 and 602 are suitable to receive a start signal STR for generating the triangular signal $v_{tri}(t)$ at one of the inputs. On the other hand, a timing digital signal or clock signal CK can be applied to the other input of said digital gates.

Particularly, such as shown in Fig. 2, the clock signal CK can be directly applied to the first gate NAND 601, whereas the second gate NAND 602 receives the opposite of this digital signal CK generated by a first inverter 604.

For example, the clock signal CK is a pulse train having a constant frequency $f_{ck}$ and duty cycle of 50%, i.e. the signal CK takes a high level for a half cycle and a low level for the subsequent half cycle.

Moreover, the selection signals $S_1$ and $S_2$ being suitable to control the gate terminals of the electronic switches $T_1$, $T_2$, $T_3$, and $T_4$ of the input device 101 are obtained by inverting the output digital signals from the gates NAND 601 and 602 by means of respective output inverters 603.

It shall be noted that, following the activation of the logic circuit 600 by means of the logic high start signal STR (logic 1), the selection signals $S_1$ and $S_2$ generated by this circuit in response to the external clock signal CK take different logic levels in each half cycle of the clock signal CK.

For example, in the half cycle where the clock signal CK is of a logic high (logic 1), the first selection signal $S_1$ is a logic 1, whereas the second selection signal $S_2$ is a logic 0.

On the other hand, in the subsequent half cycle where the clock signal CK has a logic low (logic 0), the first selection signal $S_1$ is a logic 0 and the second selection signal $S_2$ is a logic 1.

With the first logic high signal $S_1$ and second logic low signal $S_2$, the input device 101 has a first configuration in which the first $T_1$ and second $T_2$ switches are in conduction, whereas the third $T_3$ and fourth $T_4$ are disabled.

In this first configuration, the first input terminal IN1 of the integrator 501 is connected to the first terminal 102 of the input device 101 (through $R_2$) and the second input terminal IN2 is connected to the second terminal 103 (through $R_2'$).

Therefore, a constant current equal to $V_A/2R_2$ charges the first capacitor C, whereas a similar current, but of an opposite direction, discharges the second capacitor C'.

Consequently, with reference to the potential of the common-mode terminal CM, the potential of the first output terminal OUT1 of the integrator 501 decreases, whereas the potential of the second output terminal OUT2 increases.

On the other hand, with the first low-level signal $S_1$ and second high-level signal $S_2$, the input device 101 has a second configuration in which the third $T_3$ and fourth $T_4$ switches of the input device 101 are in conduction, whereas the first $T_1$ and second $T_2$ are disabled.

Therefore, the same constant current equal to $V_A/2R_2$ charges the second capacitor C' and an equal current, but of an opposite direction, discharges the first capacitor C.

Thereby, the potential of the first output terminal OUT1 increases, whereas the potential of the second output terminal OUT2 decreases.

It shall be noted that for subsequent cycles of the clock signal CK, the intermediate current signal $i_{int}(t)$ which is present at the input of the integrator 501, i.e. the differential current signal which is present on the input terminals IN1 and IN2, is a square wave.

Following the integration of this intermediate current signal $i_{int}(t)$, triangular signals $v_1$ and $v_2$ are generated at the output terminals OUT1 and OUT2 of the integrator 501, each of which is obtained by alternating upward and downward slopes of the potential of the output terminals OUT1 and OUT2.

It shall be noted that these triangular signals $v_1$ and $v_2$ are in phase opposition to each other. Moreover, these signals $v_1$ and $v_2$ have a peak-to-peak amplitude equal to $V_{tri}$ and a same frequency $f_{tri}$.

Accordingly, the triangular signal $v_{tri}(t)$ of the peak-to-peak amplitude $2V_{tri}$ produced by the generating device 100 can be obtained by picking up the differential signal from these terminals OUT1 and OUT2. In other words, this differential signal

$$V_{tri} = V_1 - V_2 \qquad (1)$$

and has a frequency equal to $f_{tri}$.

Advantageously, the generating device 100 of the invention is such as to generate a triangular signal $v_{tri}(t)$ in which a triangular wave slope changes when each half cycle of the external clock signal CK having a constant frequency $f_{ck}$ ends. In other words, the time of each half cycle of the triangular wave $v_{tri}(t)$ is substantially equal to the duration of a half cycle of the clock signal CK, therefore the frequency $f_{tri}$ of the triangular signal $v_{tri}(t)$ is substantially equal to the frequency $f_{ck}$ of this clock signal CK.

On the other hand, the peak value $V_{tri}$ of the triangular signal $v_{tri}(t)$ generated by the device 100 can be expressed as:

$$V_{tri} = \frac{V_A}{4R_2C} * \frac{1}{f_{tri}} \qquad (2)$$

From formula (2) it follows that the peak value $V_{tri}$ of the triangular wave may vary following changes in the power supply potential $V_A$. Moreover, this peak value $V_{tri}$ may also vary as a function of the product $R_2C$ and, in the latter case, this change may also be of 40% with process and temperature.

In order to overcome this drawback, there is provided the use of a control circuit of the known type (not shown in the figures) such as, for example, the control circuit described in the document "Analog front-end IC for 3G WCDA, T. Y. Chang et al., Digest of Technical Papers on 2002 IEEE Symposium on VLSI Circuits, Fig. 7".

Particularly, this control circuit operates in order to provide the above-mentioned control digital signals REG0, REG1, ..., REGN for varying the capacitance value of the first C and second C' capacitors.

Thereby, the numerical value of the product $R_2C$ is made proportional to a cycle $T_{ck}$ of the clock signal CK, i.e.:

$$R_2*C = k*T_{ck} \qquad (3)$$

wherein k is a proportionality constant.

Thereby, the expression (2) becomes:

$$V_{tri} = \frac{V_A}{4R_2C} * \frac{1}{f_{tri}} = \frac{V_A}{4*k*T_{ck}} * T_{ck} = \frac{V_A}{4*k} \qquad (4)$$

therefore, the peak value $V_{tri}$ of the triangular signal $v_{tri}(t)$ only varies as a function of the power supply potential $V_A$.

In other words, the generating device 100 of the triangular signal of the invention ensures a substantially constant frequency $f_{tri}$ and a triangular wave amplitude which is proportional only to the power supply potential $V_A$.

It shall be noted that said electronic switches $T_1$, $T_2$, $T_3$, and $T_4$ may also be provided either by means of P-MOS pass-transistors or by means of pairs of N-MOS and P-MOS pass-transistors connected in parallel to each other, i.e. C-MOS pass-transistors. In this case, from the example of the generating device 100 from Fig. 1, those skilled in the field will be able to modify the activation/deactivation modes of these electronic switches by means of the selection signals $S_1$ and $S_2$ in order to achieve the same results.

Advantageously, this generating device 100 is provided with a differential output, whereas the prior art triangle generator is single ended.

Moreover, the generating device 100 of the triangular signal $v_{tri}(t)$ also advantageously ensures an accurate upward and downward slope linearity of the triangular signal $v_{tri}(t)$.

It shall be noted that the generating device 100 of the triangular signal $v_{tri}(t)$ of the invention is an integrated device and can be used in numerous applications in the electronic field. For example, this generating device 100 can be used in order to manufacture class-D audio-frequency amplifiers. Particularly, this generating device 100 is integrable on the same semiconductor chip on which all the electronic components forming the circuit structure of said amplifiers are integrated.

Therefore, the circuit elements of the generating device 100 are advantageously manufactured during the same steps of the manufacturing process of all the other electronic components of the class-D amplifiers.

Obviously, to the triangular signal generating device of the invention, those skilled in the art, aiming at satisfying contingent and specific needs, will be able to carry out further modifications and variants, all of which being contemplated within the scope of protection of the invention, such as defined in the claims below.

**Claims**

1. A generating device (100) of a triangular signal ($v_{tri}(t)$) comprising:

   - an input device (101) provided with a first (102) and second (103) terminals in order to receive a first ($V_A$) and second (GND) potentials, respectively, and an output port (104, 105) in order to provide an intermediate signal (iint(t)) to be integrated;
   - an integration device (501) comprising an input port (IN1, IN2) connected to said output port and a first output port (OUT1, OUT2) in order to provide said triangular signal ($v_{tri}(t)$);

   **characterized in that** said input device comprises switching means ($T_1$, $T_2$, $T_3$, $T_4$) which can be activated/deactivated by means of external selection signals ($S_1$, $S_2$) in order to connect the input port (IN1, IN2) of the integration device (501) to said first and second terminals of the input device (101) according to alternative configurations, said external selection signals being generated in response to a timing signal (CK) having a substantially constant frequency ($f_{ck}$).

2. The device (100) according to claim 1, wherein said input port of the integration device (501) comprises a first (IN1) and second (IN2) input terminals of the differential type and wherein said output port of the input device (101) comprises a first (104) and second (105) differential output terminals connected to said first and second input terminals, respectively.

3. The device (100) according to claim 2, wherein in a first configuration said first differential input terminal (IN1) is connected to the first terminal (102) by means of first switching means ($T_1$) and the second differential input terminal (IN2) is connected to the second terminal (103) by means of second switching means ($T_2$).

4. The device (100) according to claim 2, wherein in a second configuration said first differential input terminal (IN1) is connected to the second terminal (103) by means of third switching means ($T_3$) and the second differential input terminal (IN2) is connected to the first terminal (102) by means of fourth switching means ($T_4$).

5. The device (100) according to claims 3 and 4, wherein said first ($T_1$) and second ($T_2$) switching means can be activated/deactivated by means of a first external selection signal ($S_1$) and wherein said third ($T_3$) and fourth ($T_4$) switching means can be activated/deactivated by means of a second external selection signal ($S_2$).

6. The device (100) according to claim 5, wherein said first ($T_1$), second ($T_2$), third ($T_3$) and fourth ($T_4$) switching means are electronic switches comprising pass-transistors either of the N-MOS-, P-MOS or C-MOS-type.

7. The device (100) according to claim 5, wherein said first ($S_1$) and second ($S_2$) external selection signals are two-level binary signals, said signals being capable of taking opposite levels in said first and second configurations.

8. The device (100) according to claim 5, wherein said first ($S_1$) and second ($S_2$) external selection signals are output signals from a logic circuit (600) having the timing signal (CK) as an input signal.

9. The device (100) according to claim 8, wherein said logic circuit (600) comprises:

- a first two-input digital gate NAND (601) in order to receive the timing signal (CK) and a start signal (STR), said first gate NAND being connected to an output inverter (603) in order to generate said first selection signal $(S_1)$;

- a second two-input digital gate NAND (602) in order to receive the start signal (STR) and the opposite of the timing signal (CK) through an input inverter (604), said second gate NAND being connected to a further output inverter (603) in order to generate said second selection signal $(S_2)$.

10. The device (100) according to claim 1, wherein said first output port of the integrated device (501) comprises a further first (OUT1) and further second (OUT2) output terminals of the differential type.

11. The device (100) according to claim 10, wherein the integrated device (501) comprises a first feedback electric network (503) in order to connect the first input terminal (IN1) to the further first output terminal (OUT1) and a second feedback electric network (503') in order to connect the second input terminal (IN2) to the second further output terminal (OUT2).

12. The device (100) according to claim 11, wherein said first electric network (503) comprises a resistance $(R_1)$ and a capacitor (C) of a changeable capacitance connected in parallel to each other, said resistance and said capacitor being further connected between the first input terminal (IN1) and the further first output terminal (OUT1).

13. The device (100) according to claim 12, wherein the capacitance of said capacitor (C) is adjustable by means of digital signals (REG0, REG1, ..., REGN) in order to make a numerical value of a product $R_2C$ proportional to a cycle $(T_{ck})$ of the timing signal (CK) in accordance with the expression:

$$R_2 \star C \;=\; k \star T_{ck}$$

wherein k is a proportionality constant.

14. The device (100) according to claim 1, wherein the triangular signal $(v_{tri}(t))$ generated has a respective frequency $(f_{tri})$ which is substantially equal to the frequency $(f_{ck})$ of the timing signal (CK).

15. The device (100) according to claims 1 and 13, wherein a peak value $(V_{tri})$ of the triangular signal $(v_{tri}(t))$ is substantially proportional to said first potential $(V_A)$ according to the expression

$$V_{tri} = \frac{V_A}{4R_2C} \star \frac{1}{f_{tri}} = \frac{V_A}{4 \star k \star T_{ck}} \star T_{ck} = \frac{V_A}{4 \star k}$$

16. The device (100) according to any one of the preceding claims, wherein said device is of the integrated type.

17. The device (100) according to claim 16, wherein said device can be used in order to manufacture class-D audio amplifiers.

FIG.1

FIG.2

**European Patent Office**

**EUROPEAN SEARCH REPORT**

Application Number

EP 05 42 5812

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/057115 A1 (TSECOURAS MICHAEL J) 16 May 2002 (2002-05-16) * the whole document * ----- | 1-17 | INV. H03K4/06 |
| X | VIACHESLAV SHKARUPIN: "A TRIANGLE WAVEFORM OSCILLATOR" ELECTRONIC ENGINEERING, MORGAN-GRAMPIAN LTD. LONDON, GB, vol. 62, no. 764, 1 August 1990 (1990-08-01), page 18, XP000150978 ISSN: 0013-4902 * the whole document * ----- | 1-17 | |
| X | RAAHEMI B ET AL INSTITUTE OF ELECTRICAL AND ELECTRONICS ENGINEERS: "NON-FILTERING APPLICATIONS OF SWITCHED-CURRENT CIRCUITS" PROCEEDINGS OF THE MIDWEST SYMPOSIUM ON CIRCUITS AND SYSTEMS. LAFAYETTE, AUG. 3 - 5, 1994, NEW YORK, IEEE, US, vol. VOL. 1 SYMP. 37, 3 August 1994 (1994-08-03), pages 169-172, XP000532001 ISBN: 0-7803-2429-3 * the whole document * ----- | 1-17 | TECHNICAL FIELDS SEARCHED (IPC) H03K |
| X | CHENG ET AL: "A low-frequency CMOS triangle wave generator" IEEE JOURNAL OF SOLID-STATE CIRCUITS, IEEE SERVICE CENTER, PISCATAWAY, NJ, US, vol. sc-20, no. 2, 1 April 1985 (1985-04-01), pages 649-652, XP002148814 ISSN: 0018-9200 * the whole document * ----- | 1-17 | |

-/--

The present search report has been drawn up for all claims

| Place of search | Date of completion of the search | Examiner |
|---|---|---|
| The Hague | 18 May 2006 | Meulemans, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 05 42 5812

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 667 055 A (KOZO UCHIDA) 30 May 1972 (1972-05-30) * the whole document * ----- | 1-17 | |
| X | DE 21 35 802 A1 (PHILIPS PATENTVERWALTUNG GMBH, 2000 HAMBURG) 15 March 1973 (1973-03-15) * the whole document * ----- | 1-17 | |
| X | PATENT ABSTRACTS OF JAPAN vol. 001, no. 136 (E-062), 10 November 1977 (1977-11-10) & JP 52 071966 A (MATSUSHITA ELECTRIC IND CO LTD), 15 June 1977 (1977-06-15) * abstract * ----- | 1-17 | |
| X | US 6 121 802 A (LUCIANO ET AL) 19 September 2000 (2000-09-19) * the whole document * ----- | 1-17 | |

TECHNICAL FIELDS SEARCHED (IPC)

The present search report has been drawn up for all claims

| Place of search | Date of completion of the search | Examiner |
|---|---|---|
| The Hague | 18 May 2006 | Meulemans, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

**EP 1 788 704 A1**

**ANNEX TO THE EUROPEAN SEARCH REPORT
ON EUROPEAN PATENT APPLICATION NO.**

EP 05 42 5812

18-05-2006

| Patent document cited in search report | | Publication date | Patent family member(s) | | Publication date |
|---|---|---|---|---|---|
| US 2002057115 | A1 | 16-05-2002 | NONE | | |
| US 3667055 | A | 30-05-1972 | DE | 2031770 A1 | 18-02-1971 |
| | | | FR | 2048014 A5 | 19-03-1971 |
| | | | GB | 1310959 A | 21-03-1973 |
| | | | NL | 7009335 A | 30-12-1970 |
| DE 2135802 | A1 | 15-03-1973 | NONE | | |
| JP 52071966 | A | 15-06-1977 | JP | 1050096 C | 26-06-1981 |
| | | | JP | 55041054 B | 22-10-1980 |
| US 6121802 | A | 19-09-2000 | NONE | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- The Class-D Amplifier. **W. MARSHALL LEACH, JR.** Introduction to Electroacustic and Audio Amplifier Design. Kendall/Hunt, 2001

- **T. Y. CHANG et al.** Digest of Technical Papers. *IEEE Symposium on VLSI Circuits,* 2002